# FASCICULE DE BREVET EUROPEEN

(11) **EP 3 469 627 B1**
(45) Date de publication et mention de la délivrance du brevet: **29.07.2020**
(21) Numéro de dépôt: 17742463.7
(22) Date de dépôt: 06.06.2017
(51) Int. Cl.: H01L 21/84, H01L 27/12, H01L 21/02, H01L 21/762

(54) **STRUCTURE POUR APPLICATIONS RADIOFREQUENCES**
STRUKTUR FÜR FUNKFREQUENZANWENDUNGEN
STRUCTURE FOR RADIOFREQUENCY APPLICATIONS

(30) Priorité: 08.06.2016 FR 1655266
(43) Date de publication de la demande: 17.04.2019
(73) Titulaire: Soitec, 38190 Bernin (FR)
(72) Inventeur: DESBONNETS, Eric, 38660 Lumbin (FR); RADU, Ionut, 38920 Crolles (FR); KONONCHUK, Oleg, 38570 Theys (FR); RASKIN, Jean-Pierre, 1348 Louvain-la-Neuve (BE)
(74) Mandataire: IP Trust
(86) Numéro de dépôt international: PCT/FR2017/051418
(87) Numéro de publication internationale: WO 2017/212160

(56) Documents cités:
- US-A1- 2012 025 345
- US-A1- 2014 175 598
- US-A1- 2014 210 038
- FERNANDEZ L J ET AL: "A CMOS compatible process for improved RF performance on highly doped substrates", SIGNAL PROPAGATION ON INTERCONNECTS, 2005. PROCEEDINGS. 9TH IEEE WORKS HOP ON GARMISCH-PARTENKIRCHEN, GERMANY MAY 10-13, 2005, PISCATAWAY, NJ, USA,IEEE, 10 mai 2005 (2005-05-10), pages 167-170, XP010830274, DOI: 10.1109/SPI.2005.1500935 ISBN: 978-0-7803-9054-6
- JOSEPH ALVIN ET AL: "A high-resistivity SiGe BiCMOS technology for WiFi RF front-end-IC solutions", 2013 IEEE BIPOLAR/BICMOS CIRCUITS AND TECHNOLOGY MEETING (BCTM), IEEE, 30 septembre 2013 (2013-09-30), pages 231-234, XP032586673, ISSN: 1088-9299, DOI: 10.1109/BCTM.2013.6798183 ISBN: 978-1-4799-0126-5 [extrait le 2014-04-14]

## Description

### DOMAINE DE L'INVENTION

La présente invention concerne le domaine des dispositifs radiofréquences intégrés.

### ARRIERE PLAN TECHNOLOGIQUE DE L'INVENTION

Pour la plupart des applications impliquant la transmission ou la réception de signaux radiofréquences (10 MHz à 100 GHz), les dispositifs requièrent pour leur fabrication un substrat remplissant un cahier des charges de plus en plus exigeant, tiré en particulier par l'évolution des normes de la téléphonie mobile (2G, 3G, LTE, LTE Advanced, LTE Advanced PRO, 5G ...). Les propriétés des matériaux du substrat doivent notamment garantir :
- de faibles pertes d'insertion (faible atténuation du signal) et une bonne linéarité (faible distorsion du signal à l'origine d'harmoniques), typiquement en présentant une résistivité effective, sur une large gamme de fréquences, supérieure à 1000 ohms.cm ;
- une stabilité de ces performances en température, en particulier dans la gamme d'utilisation des dispositifs [-40°C ; 150°C] ;
- une capacité suffisante de dissipation de la chaleur, typiquement grâce à une conductibilité thermique supérieure à 20 W/m.K ;
- un faible couplage capacitif entre la couche active et le substrat support, typiquement grâce à une permittivité diélectrique égale ou inférieure à celle du silicium (*ε_{silicium}* = 11).

Par ailleurs, pour répondre à des besoins en forts volumes, le substrat doit être compatible avec l'industrie du semi-conducteur, et en particulier avec les lignes de fabrication CMOS silicium. Bien sur, il doit en plus présenter un coût compétitif pour être adopté par les applications grand public, en particulier dans le domaine des télécommunications (téléphonie et réseau cellulaire, connectivité Wi-Fi, Bluetooth). Les applications spatiales et militaire sont quant à elles particulièrement sensibles aux performances et à la tenue en température.

Les dispositifs radiofréquences (RF), tels que des commutateurs et adaptateurs d'antenne, des amplificateurs de puissance, des amplificateurs faible bruit ou encore des composants passifs (R, L, C) peuvent être élaborés sur différents types de substrats.

On connaît par exemple les substrats silicium sur saphir, communément appelés SOS (pour « silicon on sapphire » selon l'appellation anglo-saxonne), qui font bénéficier les composants élaborés selon des technologies micro-électroniques dans la couche superficielle de silicium, des propriétés isolantes du substrat en saphir, indépendantes de la température, de sa conductibilité supérieure à 20 W/m.K et de sa permittivité inférieure à 11. Par exemple, les commutateurs d'antenne et amplificateurs de puissance fabriqués sur ce type de substrat présentent de très bons facteurs de mérite mais sont principalement utilisés pour des applications de niche du fait du coût global trop élevé de la solution.

On connaît également les substrats à base de silicium haute résistivité comprenant un substrat support, une couche de piégeage (de quelques centaines de nanomètres à quelques microns d'épaisseur) disposée sur le substrat support, une couche diélectrique disposée sur la couche de piégeage, et une couche de semi-conducteur disposée sur la couche diélectrique. Le substrat support présente habituellement une résistivité supérieure à 1 kOhm.cm. La couche de piégeage peut comprendre du silicium poly-cristallin non dopé. La combinaison d'un substrat support en silicium haute résistivité et d'une couche de piégeage selon l'état de l'art permet d'éliminer la couche de conduction parasite présente habituellement sous la couche d'oxyde enterré dans les substrats SOI HR (silicium sur isolant avec substrat support en silicium haute résistivité). L'homme du métier trouvera une revue des performances des dispositifs RF fabriqués sur un substrat semi-conducteur haute résistivité connu de l'état de la technique dans « Silicon-on-insulator (SOI) Technology, manufacture and applications », points 10.7 et 10.8, Oleg Kononchuk et Bich-Yen Nguyen, chez Woodhead Publishing.

Néanmoins, une couche de piégeage en poly-silicium présente l'inconvénient de subir une recristallisation partielle lors des étapes de traitements thermiques à hautes températures, ce qui contribue à diminuer la densité de pièges dans la couche. La dégradation de la performance du dispositif RF liée à cette diminution de densité de pièges peut être rédhibitoire pour certaines applications. Par ailleurs, ces substrats peinent à garantir la stabilité des performances RF sur toute la gamme de températures d'utilisation, notamment au-delà de 100°C : leur résistivité chute compte tenu de la génération de porteurs thermiques dans le substrat support et le couplage dispositif/substrat redevient un contributeur majeur d'atténuation et de distorsion du signal. On observe également des dégradations de la performance lorsque la température descend en-dessous de 0°C. Enfin, la permittivité restera très proche de celle du silicium (environ 11).

D'autres substrats supports, tels que le nitrure d'aluminium ou le carbure de silicium, rempliraient le cahier des charges des propriétés RF mais ils ne sont pas compatibles avec l'industrie du semi-conducteur standard. Leur utilisation en tant que substrat support pour un report de la couche finale de dispositifs est envisageable ; néanmoins, le coût de ces matériaux spécifiques combiné à celui des technologies de transfert de circuit reste encore trop élevé pour une adoption massive de ces solutions.

Le document US 2014/175598 décrit un exemple de substrat pour composants radiofréquences, qui comprend la formation de tranchées dans un substrat fortement résistif pour en améliorer les caractéristiques hautes fréquences.

### OBJET DE L'INVENTION

Un objet de l'invention est donc de proposer un substrat adapté pour les applications radiofréquences, remédiant à tout ou partie des inconvénients de l'art antérieur.

### BREVE DESCRIPTION DE L'INVENTION

L'invention concerne tout d'abord un substrat pour des dispositifs microélectroniques radiofréquences conformément à la revendication 1 comprenant :
- un substrat support en un premier matériau semi-conducteur de résistivité supérieure à 500 ohm.cm,
- une pluralité de tranchées dans le substrat support, remplies d'un deuxième matériau, et définissant sur une première face du substrat support, une pluralité de premières zones en premier matériau et au moins une deuxième zone en deuxième matériau.
Le substrat est remarquable en ce que :
- le deuxième matériau présente une résistivité supérieure à 10kohms.cm ;
- les premières zones présentent une dimension maximale inférieure à 10 microns et sont isolées les unes des autres par la deuxième zone.

Le rôle de la partie supérieure du substrat selon l'invention, comportant les tranchées remplies du deuxième matériau, est de bloquer le mouvement des charges mobiles pouvant être générées à proximité de la première face du substrat support afin que ce dernier conserve un niveau de résistivité haut et stable.

En effet, la restriction sur la dimension maximale des premières zones et l'isolation de ces premières zones les unes des autres par au moins une deuxième zone formée d'un matériau hautement résistif, permettent de bloquer le mouvement de potentielles charges mobiles dans le premier matériau semi-conducteur constituant le substrat support, dans la partie supérieure. Dans cette partie supérieure, les charges doivent parcourir une plus grande distance pour passer d'une première zone à une autre première zone voisine par contournement des tranchées remplies du deuxième matériau. La résistivité effective du substrat est ainsi augmentée.

Cela permet notamment d'éliminer des effets néfastes d'une conduction parasite dans un substrat sur lequel sont réalisés des dispositifs RF.

Selon l'invention,:
- la densité surfacique des premières zones et de la deuxième zone confère à une partie supérieure du substrat s'étendant de la première face du substrat support jusqu'à une profondeur des tranchées, une conductibilité thermique moyenne supérieure à 20W/m.K, une permittivité diélectrique moyenne inférieure à la permittivité du premier matériau et une résistivité supérieure à la résistivité du premier matériau.

Selon d'autres aspects de l'invention:
- la deuxième zone forme un maillage sur la première face du substrat support ;
- la profondeur des tranchées est comprise entre 1 micron et 100 microns ;
- le premier matériau constituant le substrat support est du silicium ;
- le deuxième matériau remplissant les tranchées est choisi parmi un oxyde de silicium, un nitrure de silicium, un oxynitrure de silicium, un nitrure d'aluminium, un silicium amorphe ou poly-cristallin, un silicium riche en carbone, un polymère ou encore un gaz ;
- la pluralité de tranchées est remplie partiellement du deuxième matériau et partiellement d'un troisième matériau, de nature ou de composition différente du deuxième matériau ;
- le troisième matériau est choisi parmi un oxyde de silicium, un nitrure de silicium, un oxynitrure de silicium, un nitrure d'aluminium, un silicium amorphe ou polycristallin, un silicium riche en carbone, un polymère ou encore un gaz ;
- le deuxième matériau ou le troisième matériau présente des propriétés de piégeage des charges électriques mobiles susceptibles d'être générées dans le premier matériau ;
- le substrat comprend une couche diélectrique disposée sur la première face du substrat support ;
- le substrat comprend une couche additionnelle entre la couche diélectrique et la première face du substrat support, composée du troisième matériau ;
- la couche diélectrique est formée d'un matériau choisi parmi un oxyde de silicium, un nitrure de silicium, un oxynitrure de silicium, un nitrure d'aluminium ;
- la couche diélectrique est composée du deuxième matériau ;
- le substrat comprend une couche utile disposée sur la première face du substrat support ;
- la couche diélectrique est intercalée entre la couche utile et la première face du substrat support ;
- la couche utile est composée d'un matériau choisi parmi les matériaux semi-conducteurs, isolants ou conducteurs, ou encore les matériaux piézoélectriques.

L'invention concerne également une structure de dispositifs microélectroniques radiofréquences comprenant :
- un substrat tel que ci-dessus ;
- une couche de dispositifs microélectroniques disposée sur le substrat.

Selon des caractéristiques avantageuses de l'invention, prises seules ou en combinaison, le dispositif microélectronique est un commutateur ou adaptateur d'antenne ou un amplificateur de puissance ou un amplificateur faible bruit ou un composant passif ou un composant MEMS radiofréquence ou un filtre radiofréquence ou autre circuit fonctionnant à hautes fréquences.

L'invention concerne en outre un procédé de fabrication d'un substrat pour des dispositifs microélectroniques radiofréquences, conformément à la revendication 17, comprenant entre autres caractéristiques :
- La fourniture d'un substrat support en un premier matériau semi-conducteur de résistivité supérieure à 500 ohm.cm, comportant une première face ;
- La gravure selon un masque d'une pluralité de tranchées s'étendant de la première face du substrat support jusqu'à une profondeur déterminée ;
- Le remplissage de la pluralité de tranchées avec un deuxième matériau pour former, sur la première face, des premières zones en premier matériau et au moins une deuxième zone en deuxième matériau ;

L'invention concerne enfin un procédé de fabrication d'un substrat pour des dispositifs microélectroniques radiofréquences, conformément à la revendication 18, comprenant entre autres caractéristiques :
- La fourniture d'un substrat support en un premier matériau semi-conducteur de résistivité supérieure à 500 ohm.cm ;
- Le dépôt local, selon un masque, d'une pluralité de piliers formés du premier matériau et d'une hauteur déterminée, sur le substrat support ; une surface supérieure des piliers définissant une première face du substrat et les piliers étant isolés les uns des autres par une pluralité de tranchées s'étendant de la première face du substrat jusqu'à une profondeur définie par la hauteur déterminée des piliers ;
- Le remplissage de la pluralité de tranchées avec un deuxième matériau pour former, sur la première face, des premières zones en premier matériau et au moins une deuxième zone en deuxième matériau.

### BREVE DESCRIPTION DES DESSINS

D'autres caractéristiques et avantages de l'invention ressortiront de la description détaillée de l'invention qui va suivre en référence aux figures annexées sur lesquelles :
- les figures la à 1d présentent des étapes du procédé de fabrication d'un substrat conforme à l'invention ;
- les figures 2 et 3 présentent deux variantes de substrats conformes à l'invention, en vue de dessus et en coupe ;
- les figures 4a et 4b présentent d'autres variantes de substrats conformes à l'invention, en vue en coupe ;
- les figures 5a, 5b, 6a à 6d, et 9 présentent des substrats conformes à l'invention ;
- les figures 7 et 8 présentent des structures de dispositifs microélectroniques radiofréquences conformes à l'invention ;
- la figure 10 présente un graphe représentant la résistivité effective du substrat, en fonction de la fréquence de fonctionnement de dispositifs microélectroniques radiofréquences, dans des structures conformes à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

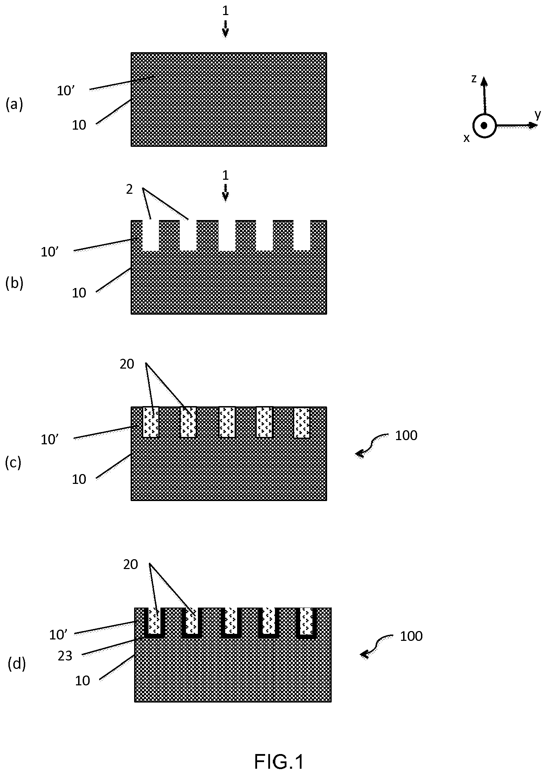

L'invention concerne un procédé de fabrication d'un substrat adapté pour des dispositifs microélectroniques radiofréquences, présenté sur les figures la à 1c. Le procédé comprend la fourniture d'un substrat support 10 en un premier matériau 10' semi-conducteur de résistivité supérieure à 500 ohms.cm (figure 1a). Avantageusement, la résistivité du premier matériau sera même choisie supérieure à 1000 ohms.cm, voire supérieure à 3000 ohms.cm. A titre d'exemple, le premier matériau 10' pourra être du silicium monocristallin.

Le procédé selon l'invention comporte également une étape de gravure de la première face 1 du substrat 10, selon un masque, d'une pluralité de tranchées 2 s'étendant de la première face 1 du substrat support 10 jusqu'à une profondeur déterminée. Cette étape de gravure pourra être précédée d'une étape de photolithographie classiquement mise en œuvre pour définir les motifs à graver selon ledit masque et protéger les motifs ne devant pas être gravés par une couche de masquage. La gravure pourra être effectuée par des techniques connues d'attaque chimique, humide ou sèche. La couche de masquage déposée sur la première face 1 du substrat support 10 pourra alors être retirée, menant à l'obtention du substrat 10 comportant les tranchées 2, illustré sur la figure 1b.

Selon une variante, les tranchées 2 pourront être réalisées par le dépôt local, selon un masque, d'une pluralité de piliers formés du premier matériau et d'une hauteur déterminée, sur le substrat support 10. Après dépôt, la surface supérieure des piliers définit une première face du substrat 10 et les piliers sont isolés les uns des autres par une pluralité de tranchées s'étendant de ladite première face jusqu'à une profondeur, définie par la hauteur des piliers. Un tel dépôt local pourra par exemple être réalisé par épitaxie sélective : dans ce cas, les zones devant être exemptes de dépôt sont recouvertes par une couche de masquage (en particulier de l'oxyde ou du nitrure de silicium). L'épitaxie s'opère alors localement, sur les zones non masquées. Après épitaxie, la couche de masquage présente au fond des tranchées peut être conservée ou retirée par gravure humide ou sèche.

Le procédé de fabrication comprend en outre une étape de remplissage de la pluralité de tranchées 2 avec un deuxième matériau 20. Le deuxième matériau 20 sera choisi pour ses propriétés électriques : il présentera en particulier une résistivité supérieure à 10kohms.cm. Le deuxième matériau 20 pourra être choisi parmi des isolants électriques, tels que l'oxyde de silicium, le nitrure de silicium, un oxy-nitrure de silicium, le nitrure d'aluminium. Il pourra alternativement être choisi parmi des semi-conducteurs fortement résistifs tels que le silicium amorphe, poly-cristallin, intrinsèque ou avec des compositions choisies par exemple pour stabiliser la résistivité en température (notamment Si dopé Carbone ou silicium riche en carbone). Enfin, le deuxième matériau 20 pourra également être choisi parmi des polymères isolants.

A titre d'exemple, l'étape de remplissage des tranchées 2 pourra être réalisée par dépôt chimique, en phase vapeur ou liquide ou par traitement thermique (par exemple par oxydation thermique dans le cas d'un remplissage par de l'oxyde de silicium). Avantageusement, le deuxième matériau 20 pourra supporter des traitements thermiques élevés (notamment jusqu'à 1000°C, voire 1200°C), requis pour la fabrication subséquente de certains dispositifs RF. Dans certains cas, le deuxième matériau 20 n'aura à subir que des traitements à moyennes ou basses températures (inférieures à 500°C, voire 350°C), lors des étapes subséquentes de fabrication des dispositifs sur le substrat 100 : cela autorisera d'autres options pour le deuxième matériau 20, comme des polymères, par exemple déposés par des techniques de type « solgel » (dépôt par centrifugation).

Le substrat 100 obtenu à ce stade du procédé de fabrication est illustré sur la figure 1c.

Selon une variante illustrée en figure 1d, les tranchées 2 pourront être remplies partiellement par le deuxième matériau 20 et partiellement par un troisième matériau 23, de nature et/ou de composition différente du deuxième matériau 20. Le troisième matériau 23 pourra être choisi parmi les matériaux énoncés comme pouvant constituer le deuxième matériau 20. Avantageusement, le troisième matériau 23 sera d'abord déposé sur les parois internes des tranchées 2 ; le deuxième matériau 20 étant ensuite déposé sur le troisième matériau 23, pour remplir les tranchées 2. A titre d'exemple et sans que cela soit considéré comme limitatif, un premier dépôt de silicium poly-cristallin pourra être effectué sur les parois internes des tranchées 2 ; un deuxième dépôt de nitrure de silicium pourra ensuite être opéré, sur le silicium poly-cristallin, pour remplir les tranchées 2. Dans cet exemple, le troisième matériau 23 est en silicium poly-cristallin et le deuxième matériau 20 est en nitrure de silicium.

Selon une autre variante, les tranchées 2 pourront être conservées à l'état de cavités, c'est-à-dire sans remplissage de matériau solide. Le deuxième matériau 20 est dans ce cas constitué par un gaz ou un mélange gazeux, par exemple d'air ou d'autres gaz qui pourront être introduits ultérieurement au cours du procédé de fabrication selon l'invention.

Selon cette variante, un troisième matériau 23 pourra également être déposé sur les parois internes des tranchées 2, la majeure partie de la tranchée 2 n'étant par ailleurs remplie que par un gaz ou un mélange gazeux.

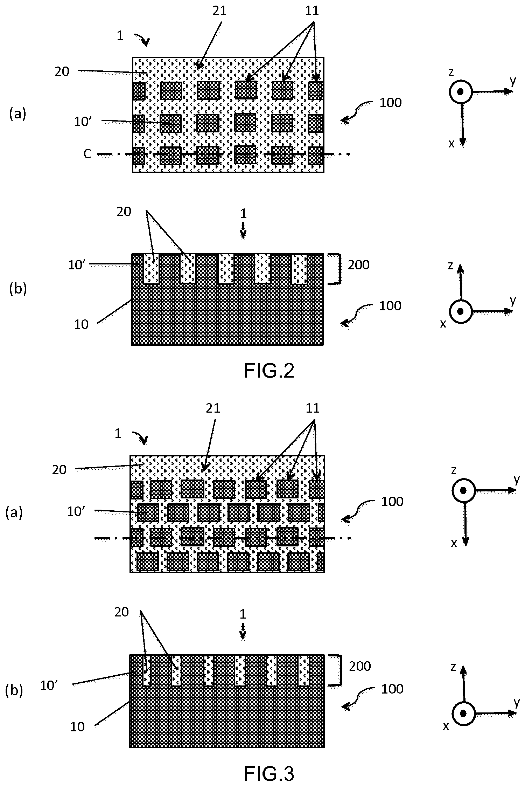

La figure 2a illustre un substrat 100 en vue de dessus, c'est-à-dire selon la première face 1. Notons que la vue en coupe du même substrat 100, selon un plan de coupe C illustré sur la figure 2a, est présentée sur la figure 2b.

Les tranchées 2 remplies par le deuxième matériau 20 forment sur la première face 1 une pluralité de premières zones 11 en premier matériau 10' et au moins une deuxième zone 21 en deuxième matériau 20. Le substrat 100 est remarquable en ce que les premières zones 11 ont une dimension maximale inférieure à 10 microns. Selon d'autres modes de mise en œuvre avantageux, la dimension maximale des premières zones 11 sera même inférieure à 8 microns, à 5 microns, voire à 2 microns.

Le substrat 100 est également remarquable en ce que les premières zones 11 sont isolées les unes des autres par la deuxième zone 21 en deuxième matériau 20, c'est-à-dire qu'elles ne sont pas en contact les unes avec les autres. Avantageusement, elles sont isolées électriquement les unes des autres, le deuxième matériau 20 présentant une résistivité supérieure à 10kohms.cm. Avantageusement, le deuxième matériau 20 ou le troisième matériau 23 quand il est mis en œuvre, présente des propriétés de piégeage des charges électriques mobiles susceptibles d'être générées dans le premier matériau 10'.

Selon les exemples présentés en figures 2a et 3a, la au moins une deuxième zone 21 forme un maillage sur la première face 1 du substrat support 10, qui cloisonne chacune des premières zones 11. Selon la forme de ce maillage et selon les dimensions des zones 11,21, la densité surfacique des premières zones 11 pourra être différente. Selon l'invention, la densité surfacique des premières zones 11 sera choisie de manière à conférer à une partie supérieure 200 du substrat 100, s'étendant de la première face 1 du substrat support 10 jusqu'à la profondeur des tranchées 2, une conductibilité thermique moyenne supérieure à 20W/m.K, une permittivité diélectrique moyenne inférieure à la permittivité du premier matériau 10' et une résistivité effective supérieure à la résistivité du premier matériau 10' ou au moins supérieure à 1000 ohms.cm.

A titre d'exemple, les premières zones 11 pourront couvrir entre 20 et 70% de la surface de la première face 1 du substrat support 10, la deuxième zone 21 couvrant la surface complémentaire.

Les tranchées 2 présentent une profondeur comprise entre 1 micron et 100 microns. Pour un dispositif microélectronique (qui sera disposé ultérieurement au-dessus de la partie supérieure 200 du substrat 100) de dimension latérale a, on peut considérer que le champ électrique va pénétrer sur une profondeur de l'ordre de a/3 dans le substrat 100. Ainsi, pour un dispositif de type commutateur d'antenne RF, de dimension latérale typique de 100 microns, la profondeur des tranchées 2 devra être de l'ordre de 30-40 microns, pour que le champ électrique ne voit que la partie supérieure 200 su substrat 100. Les caractéristiques électriques (résistivité effective, permittivité) de la partie supérieure 200 conditionneront alors la performance des dispositifs microélectroniques radiofréquences disposés au-dessus.

Les techniques connues de gravure permettent de réaliser des tranchées dont le facteur de forme (rapport dimension latérale / profondeur) est habituellement compris entre 1/5 et 1/30. A titre d'exemple, le facteur de forme des tranchées 2 selon l'invention sera typiquement compris entre 1/5 et 1/30 : pour une dimension latérale maximale de 10 microns, la profondeur des tranchées 2 pourra être comprise entre 50 et 100 microns ; pour une dimension latérale maximale de 1 micron, la profondeur pourra être comprise entre 5 microns et 30 microns.

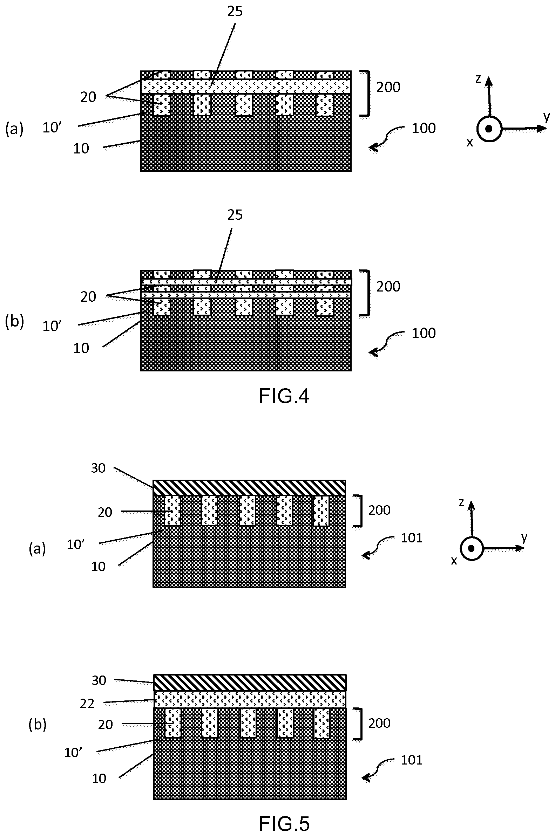

Les figures 4a et 4b présentent une variante de réalisation du substrat 100 selon l'invention. Dans la partie supérieure 200 du substrat 100, les parties constituées du premier matériau 10' peuvent être segmentées dans le sens de la profondeur (c'est-à-dire selon l'axe z sur les figures). Pour cela, au moins une couche de segmentation 25 en deuxième matériau 20 pourra être déposée sur toute la surface de la première face 1 du substrat support 10 après le remplissage des tranchées 2. Cette couche de segmentation 25 pourra être en un des deuxièmes matériaux 20 évoqués précédemment, identique ou différent de celui utilisé pour remplir les tranchées 2.

Des étapes subséquentes de dépôt local du premier matériau 10' en vis-à-vis des premières zones 11 et du deuxième matériau 20 en vis-à-vis des deuxièmes zones 21 seront ensuite opérées. Ces étapes pourront être répétées autant de fois que besoin pour réaliser plusieurs segmentations dans l'épaisseur de la partie supérieure 200.

Alternativement, la segmentation des parties constituées du premier matériau 10' dans la partie supérieure 200 pourra être réalisée par implantation ionique dans le substrat 100. A titre d'exemple, des espèces choisies parmi l'oxygène, l'azote, l'hydrogène, l'hélium, etc... pourront être introduites à une profondeur déterminée, pour constituer la couche 25 segmentant en profondeur les parties en premier matériau 10' de la partie supérieure 200.

Le procédé de fabrication du substrat pour des dispositifs microélectroniques radiofréquences selon l'invention peut en outre comporter une étape de formation d'une couche diélectrique 30 sur la première face 1 du substrat support 10 (figure 5a). A titre d'exemple, son épaisseur pourra varier entre quelques nanomètres et 3µm. Avantageusement, la couche diélectrique 30 est formée d'un matériau choisi parmi l'oxyde de silicium, le nitrure de silicium, un oxynitrure de silicium ou le nitrure d'aluminium. Elle pourra être déposée par différentes techniques connues de dépôt chimique. La couche diélectrique 30 pourra optionnellement être de même nature que le deuxième matériau 20.

Selon une variante, illustrée en figure 5b, une couche en deuxième matériau est présente sous la couche diélectrique 30. En effet, lors de l'étape de remplissage des tranchées 2 du procédé selon l'invention, une couche de deuxième matériau 20 peut être déposée dans les tranchées 2 et sur la première face 1 du substrat support 10. Une étape de planarisation de cette couche (par exemple un polissage mécano-chimique) peut ensuite être opérée pour résorber la topologie de surface, en laissant une couche résiduelle 22 en deuxième matériau 20 sur la première face 1 du substrat support 10.

Selon une autre variante non représentée, la couche résiduelle 22 peut constituer tout ou partie de la couche diélectrique 30.

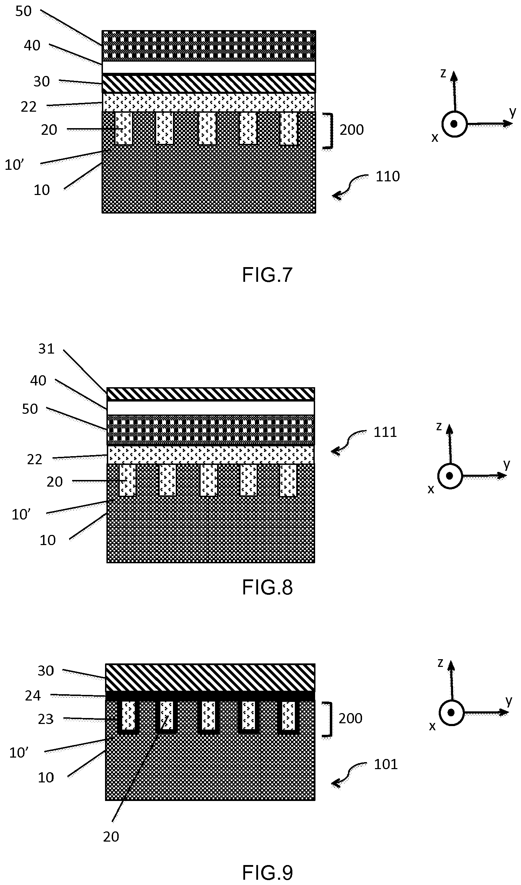

Le procédé de fabrication peut également comporter une étape de formation d'une couche additionnelle 24 sur la première face 1 du substrat support 10, préalablement à la formation de la couche diélectrique 30 (figure 9). Avantageusement cette couche additionnelle 24 est composée du troisième matériau 23, ce dernier présentant des propriétés de piégeage des charges électriques mobiles (porteurs libres) susceptibles d'être générées dans le premier matériau 10'.

Le procédé de fabrication du substrat pour des dispositifs microélectroniques radiofréquences selon l'invention peut également comporter une étape de formation d'une couche utile 40, disposée sur un substrat 100 ou 101 selon l'invention.

A titre d'exemple, la couche utile 40 est reportée par un des procédés de transfert de couches minces bien connus de l'homme du métier, parmi lesquels :
- le procédé Smart Cut™, basé sur une implantation d'ions légers d'hydrogène et/ou d'hélium dans un substrat donneur et un collage par exemple par adhésion moléculaire de ce substrat donneur sur le substrat 100 ou 101 ; une étape de détachement permet ensuite de séparer une couche mince superficielle du substrat donneur (la couche utile), au niveau du plan de fragilisation défini par la profondeur d'implantation des ions. Des étapes de finition, pouvant inclure des traitements thermiques à haute température, confèrent enfin la qualité cristalline et de surface requise à la couche utile 40. Ce procédé est particulièrement adapté pour la fabrication de couches utile très minces, d'épaisseur comprise entre quelques nanomètres et environ 1,5µm par exemple pour les couches de silicium.
- le procédé Smart Cut suivi d'une étape d'épitaxie, permettant notamment d'obtenir des couches utiles 40 plus épaisses, par exemple de quelques dizaines de nm à 20µm.
- les procédés de collage direct et d'amincissement mécanique, chimique et/ou mécano-chimique ; ils consistent à assembler un substrat donneur par adhésion moléculaire directement sur le substrat 100 ou 101, puis à amincir le substrat donneur jusqu'à l'épaisseur souhaitée de couche utile 40, par exemple par rodage (« grinding » selon la terminologie anglo-saxonne) et par polissage (CMP pour « chemical mechanical polishing »). Ces procédés sont particulièrement adaptés au report de couches épaisses, par exemple de quelques microns à plusieurs dizaines de microns, et jusqu'à quelques centaines de microns.

Les procédés de transfert de couches précités sont avantageusement basés sur une étape de collage par adhésion moléculaire d'un substrat donneur (dont sera issue la couche active) et du substrat support 100, 101. Dans le cas particulier où le deuxième matériau 20 remplissant les tranchées 2 est un gaz ou un mélange gazeux, l'atmosphère dans l'enceinte de collage sera contrôlée (composition du gaz, pression...) de manière à ce que le gaz piégé dans les tranchées 2 après l'assemblage des deux substrats corresponde au deuxième matériau 20 attendu. L'atmosphère dans l'enceinte de collage pourra notamment être amenée à une très faible pression, pour arriver à une configuration de quasi-vide dans les tranchées 2, ce type de configuration pouvant être dans certains cas, favorables à la tenue mécanique de la couche utile 40 superficielle.

La couche utile 40 est composée d'un matériau ou empilement de matériaux permettant de mettre en œuvre des dispositifs RF, analogues ou digitaux. Elle pourra ainsi être choisi parmi les matériaux semi-conducteurs, conducteurs ou isolants selon le type de dispositifs RF visé; plus spécifiquement, elle pourra être composée d'un matériau choisi parmi les matériaux piézoélectriques.

La couche utile 40 pourra par exemple être en silicium, en silicium germanium, en germanium, en matériau III-V, en niobate de lithium, en tantalate de lithium, en nitrure d'aluminium, en PZT, etc.

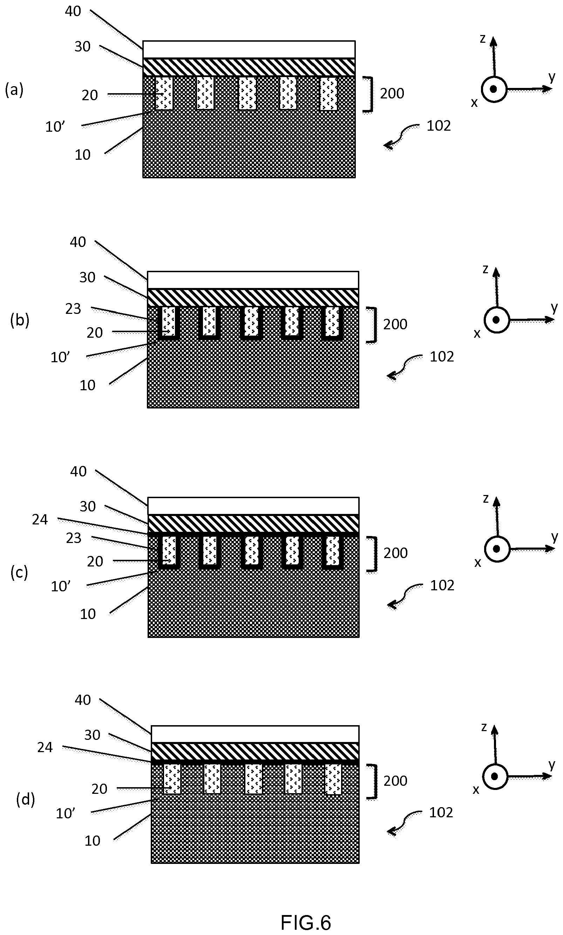

Les figures 6a, 6b et 6c illustrent des substrats 102 selon l'invention, comportant :
∘ une couche utile 40,
∘ une couche diélectrique 30
∘ un substrat 100 comprenant un substrat support 10 en un premier matériau 10' et :
   ▪ des tranchées 2 remplies par un deuxième matériau 20 (figure 6a) ;
   ▪ des tranchées 2, dont les parois sont tapissées par un troisième matériau 23, et qui sont remplies par un deuxième matériau 20 (figure 6b) ;
   ▪ des tranchées 2, dont les parois sont tapissées par un troisième matériau 23, et qui sont remplies par un deuxième matériau 20 ; une couche additionnelle 24 étant intercalée entre la première face du substrat support 10 et la couche diélectrique 30 (figure 6c).

Comme bien connu dans le domaine des substrats SOI pour les applications radiofréquences, une couche diélectrique, par exemple formée par un oxyde de silicium sur un substrat support en silicium, comporte des charges positives. Ces charges sont compensées par des charges négatives venant du substrat support, au niveau de l'interface avec la couche diélectrique. Ces charges génèrent une couche de conduction parasite de surface dans le substrat support, sous la couche diélectrique : la résistivité du substrat support au niveau de cette couche de conduction chute alors autour de 10-100ohm.cm. Les performances électriques sensibles à la résistivité du substrat support (comme la linéarité du signal, le niveau de pertes d'insertion, les facteurs de qualité des composants passifs, ...) sont donc fortement dégradées par la présence de cette couche de conduction.

Le rôle de la partie supérieure 200 du substrat 102 est notamment de bloquer le mouvement des charges mobiles générées à proximité de la première face du substrat support 10, afin qu'il conserve un niveau de résistivité haut et stable.

En effet, la restriction sur la dimension maximale des premières zones 11 permet de bloquer le mouvement de potentielles charges mobiles dans le premier matériau 10' semi-conducteur constituant le substrat support 10. Les charges doivent parcourir une plus grande distance pour passer d'une première zone 11 à une autre première zone 11 voisine par contournement des tranchées 2 remplies du deuxième matériau 20. La résistivité effective de la partie supérieure 200 du substrat 102 est ainsi augmentée. Cela permet d'éliminer tout ou partie des effets néfastes d'une conduction parasite qui apparaît sous la couche diélectrique 30 dans un substrat 102 comportant des dispositifs RF.

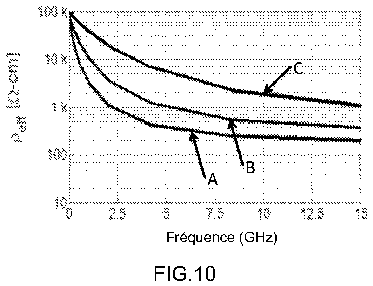

A titre d'exemple, prenons le cas d'un substrat 102 tel qu'illustré sur la figure 6b, formé d'un substrat support 10 en silicium monocristallin de résistivité nominale à 8kohms.cm, d'un troisième matériau 23 en silicium poly-cristallin déposé, d'un deuxième matériau 20 en dioxyde de silicium déposé, les tranchées 2 ayant une profondeur de 20 microns ; la couche diélectrique 30 est également en dioxyde de silicium et la couche utile 40 est en silicium monocristallin. La figure 10 montre une simulation de l'évolution de la résistivité effective de la partie supérieure 200 du substrat support 10 en fonction de la fréquence de fonctionnement des dispositifs radiofréquences présents dans et/ou sur la couche utile 40. Les variantes A, B et C sur la figure 10 correspondent à trois dimensions maximales différentes des premières zones 11 : 10 microns (A), 5 microns (B) et 2 microns (C). La variante A montre que la résistivité effective de la partie supérieure 200 reste supérieure à 1000 ohms.cm pour les fréquences inférieures à environ 2,5GHz. La variante B permet de conserver une résistivité effective supérieure à 1000 ohms.cm pour toutes les fréquences inférieures à 5GHz. Enfin, la variante C permet d'obtenir une résistivité effective de la partie supérieure 200 supérieure à la résistivité nominale du substrat support 10 pour les fréquences inférieures à 5GHz ; elle permet en outre de conserver une résistivité effective supérieure à 1000 ohms.cm pour toutes les fréquences inférieures à 15GHz. Le confinement dans les premières zones 11 des charges mobiles générées dans le premier matériau 10' (silicium) sous la couche diélectrique 30 d'oxyde de silicium permet ainsi d'augmenter la résistivité effective de la partie supérieure 200 du substrat support 10 : plus les dimensions des premières zones 11 sont réduites plus la résistivité effective augmente et reste élevée sur une large gamme de fréquences.

La permittivité de la partie supérieure 200 est par ailleurs améliorée par rapport à la permittivité du substrat support 10 initial (silicium), du fait de la présence du deuxième matériau 20 (dioxyde de silicium) dans les tranchées 2.

La densité des premières 11 et deuxième 21 zones est choisie pour conserver une conductibilité thermique moyenne du substrat support 11 supérieure à 20W/m.K, ceci en jouant sur les dimensions (dans le plan (x,y)) de la deuxième zone 21.

Enfin, la stabilité des performances RF au-delà de 100°C pourra être améliorée dans la partie supérieure 200 du substrat 10 du fait de la présence du troisième matériau 23 (silicium poly-cristallin) sur les parois internes des tranchées 2, le troisième matériau 23 présentant avantageusement des propriétés de piégeage des charges électriques mobiles ; en effet, au moins une partie des porteurs thermiques générés dans le premier matériau 10' entre les tranchées 2 va être piégée au niveau du troisième matériau 23, sur toute la profondeur des tranchées 2, pour conférer à la partie supérieure 200 une résistivité effective plus stable sur une gamme étendue de températures.

Des performances de résistivité effective à température ambiante, de permittivité et de conductibilité thermique sensiblement similaires sont attendues avec un substrat 102 tel qu'illustré sur la figure 6a, formé par exemple d'un substrat support 10 en silicium monocristallin de résistivité nominale à 8kohms.cm, d'un deuxième matériau 20 de type gaz ou mélange de gaz (air ou azote à pression atmosphérique ou à une pression contrôlée inférieure), les tranchées 2 ayant une profondeur de 20 microns ; la couche diélectrique 30 est également en dioxyde de silicium et la couche utile 40 est en silicium monocristallin.

Selon un autre exemple, un substrat 102 selon la figure 6a dont le deuxième matériau 20 (remplissant les tranchées 2) est en poly-silicium fortement résistif devrait présenter des performances améliorées en ce qui concerne la stabilité de la résistivité effective sur une large gamme de températures et la conductibilité thermique de la partie supérieure 200 ; la permittivité de la partie supérieure 200 resterait en revanche proche de celle du substrat support 10 (silicium).

Selon encore un autre exemple, prenons le cas d'un substrat 102 tel qu'illustré sur la figure 6c, formé d'un substrat support 10 en silicium monocristallin de résistivité nominale à 8kohms.cm, d'un troisième matériau 23 en silicium poly-cristallin déposé, d'un deuxième matériau 20 en dioxyde de silicium ou en nitrure de silicium déposé, les tranchées 2 ayant une profondeur de 20 microns ; la couche additionnelle 24 est en poly-silicium, la couche diélectrique 30 est également en dioxyde de silicium et la couche utile 40 est en silicium monocristallin.

Les performances en terme de résistivité effective de la partie supérieure 200 sur des gammes de fréquences élevées (typiquement jusqu'à 50GHz) sont encore significativement améliorées par rapport aux exemples précédents : la résistivité effective atteint des valeurs de l'ordre de 30kohms.cm. Dans cet exemple, la présence de la couche additionnelle 24 en troisième matériau 23 (poly-silicium) sous la couche diélectrique 30 permet de piéger efficacement les porteurs libres générés dans les premières zones 11. Le confinement (dans les premières zones 11) des charges mobiles résiduelles, présentes dans le premier matériau 10', permet d'augmenter encore la résistivité effective de la partie supérieure 200 du substrat support 10.

La dimension maximale des premières zones 11 est avantageusement choisie en fonction des dispositifs qui seront élaborés sur le substrat 102 et notamment en fonction de leur taille : par exemple, pour un dispositif de type commutateur d'antenne comportant des transistors caractérisés par une longueur de canal inférieure à 0,3 micron et une largeur de canal supérieure à 500 microns, la dimension maximale (dans le plan (x,y) sur les figures) des premières zones 11 sera choisie de l'ordre de 1 micron.

En règle générale, la dimension maximale des premières zones 11 et les dimensions de la deuxième zone 21 sont choisies de sorte que chaque composant « voit » le substrat 102 comme un substrat sensiblement homogène c'est-à-dire que le dispositif ne soit pas disposé, soit uniquement au-dessus d'une première zone 11, soit uniquement au-dessus de la deuxième zone 21 : avantageusement, le composant (ici le transistor) présente au moins une dimension qui s'étend au-dessus d'une pluralité de premières zones 11. Cela permet notamment de limiter les contraintes mécaniques inhomogènes au niveau desdits composants, susceptibles de générer une plus grande dispersion dans les caractéristiques électriques des composants.

La profondeur des tranchées 2, et donc l'épaisseur de la partie supérieure 200 du substrat 101, est également définie selon le type de dispositifs RF qui sera élaboré sur le substrat 102 (ou sur le substrat 100 ou 101). En particulier, cette profondeur est choisie en fonction de la puissance générée par les dispositifs et de la profondeur de pénétration de champ électromagnétique dans le substrat 102. Par exemple, pour un dispositif de type commutateur d'antenne commutant une puissance de 1 watt, la pénétration du champ étant de l'ordre de 50 microns, la profondeur des tranchées 2 sera choisie de l'ordre de 50 microns, soit typiquement entre 30 à 70 microns.

Avantageusement, pour des dispositifs RF fonctionnant à des fréquences supérieures à 100MHz, le deuxième matériau 20 ou le troisième matériau quand il est mis en œuvre, présente des propriétés de piégeage des charges électriques mobiles susceptibles d'être générées dans le premier matériau 10', comme présenté précédemment dans certains exemples de substrats 102.

L'invention concerne également une structure 110 de dispositifs microélectroniques radiofréquences (illustrée sur la figure 7) comprenant :
- un substrat 100 ou 101 ou 102 tel que défini par la revendication 1;
- une couche de dispositifs microélectroniques 50 disposée directement sur le substrat 100, 101 ou sur la couche diélectrique 30, elle-même disposée sur le substrat 100,101.

Selon un mode de réalisation de l'invention, le dispositif microélectronique 50 de la structure 110 pourra être un commutateur ou adaptateur d'antenne ou un amplificateur de puissance ou un amplificateur faible bruit ou encore un composant passif (R, L, C).

A titre d'exemple pour la fabrication de ce type de dispositifs, on pourra utiliser un substrat 102 présentant une couche utile 40 en silicium d'épaisseur comprise entre 10nm et 1,5 micron, par exemple 145nm, et une couche diélectrique 30 sous-jacente en oxyde de silicium d'épaisseur comprise entre 20nm et 2 microns, par exemple 400nm ; les premières zones 11 ont la forme de carrés de 1 microns de coté, espacés de 2 microns et la partie supérieure 200 s'étend sur 50 microns d'épaisseur (profondeur des tranchées 2 remplies par le deuxième matériau 20). Le premier matériau 10' est du silicium monocristallin et le deuxième matériau 20 est du nitrure de silicium. Optionnellement, selon la fréquence d'utilisation des composants visés, une couche de silicium poly-cristallin enrichi en carbone, correspondant au troisième matériau 23, pourra tapisser les parois des tranchées 2, intercalée entre le premier 10' et le deuxième 20 matériaux ; elle pourra présenter une épaisseur de quelques dizaines de nm à 200nm. Selon encore une autre option, une couche additionnelle 24 en silicium poly-cristallin pourra être intercalée entre la première face du substrat support 10 et la couche diélectrique 30 ; la couche additionnelle 24 pourra présenter une épaisseur allant typiquement de 100nm à 1 micron.

La couche de dispositifs 50 élaborée dans et sur la couche utile 40 comprend une pluralité de composants actifs (de type MOS, bipolaires, ...) et une pluralité de composants passifs (de type capacités, inductances, résistances,...).

La fabrication des composants microélectroniques nécessite la réalisation de plusieurs étapes dont des traitements thermiques à hautes températures, typiquement à 950-1100°C, voire au-delà. La partie supérieure 200 du substrat 110, constituée de silicium (premier matériau 10'), de nitrure de silicium (deuxième matériau 20) et éventuellement de poly-silicium enrichi en carbone (troisième matériau) est apte à supporter ce type de traitement sans subir de dégradation susceptible d'impacter ses propriétés RF.

Selon une variante, la couche de dispositifs 50 peut être d'abord élaboré sur un substrat de type SOI, puis reporté par une technique de transfert de couches connue de l'homme du métier, sur un substrat 100 ou 101 selon l'invention, pour former une structure 111 illustrée en figure 8.

Sur la figure 8, la structure 111 comprend, d'une part, le substrat support 10 comportant la pluralité de tranchées 2, remplies du deuxième matériau 20, sur lequel est optionnellement disposée une couche résiduelle 22 en deuxième matériau 20 faisant office de couche diélectrique. Au-dessus de cette dernière, se présente la couche de dispositifs 50 : la partie dite « back end » de couches d'interconnexions métalliques et de diélectriques est disposée au-dessus de la couche résiduelle 22, la partie dite « front end » (silicium), élaborée en partie dans la couche utile 40, étant elle-même au-dessus de la partie « back-end ». Enfin, on trouve au-dessus la couche utile 40 et optionnellement une couche diélectrique 31.

Dans les deux cas de figures pré-cités, les champs électromagnétiques, issus des signaux hautes fréquences destinés à se propager dans les dispositifs 50, et qui vont pénétrer dans le substrat 100,101,102 ne subiront que de faibles pertes (pertes d'insertion) et distorsions (harmoniques), du fait de la résistivité effective, supérieure à la résistivité nominale du premier matériau 10' du substrat support 10 ou au moins supérieure à 1000ohms.cm, et stable sur toute la gamme de températures d'utilisation [-40°C ; 150°C], de la partie supérieure 200 de la structure 110,111 : en effet, la configuration de la partie supérieure 200 selon l'invention bloque le mouvement des charges mobiles dans le substrat support semi-conducteur (issues de la couche de conduction parasite ou des donneurs thermiques). De manière avantageuse, la structure 110,111 présentera des propriétés favorables de dissipation thermique, le premier matériau étant du silicium. De manière également avantageusement, le couplage capacitif entre la couche de dispositifs 50 et le substrat support 10 sera fortement diminué du fait de la permittivité moyenne de la partie supérieure 200, réduite par rapport à celle du silicium par la présence des tranchées remplies du deuxième matériau (hautement résistif ou isolant).

Selon un autre mode de réalisation de l'invention, le dispositif microélectronique 50 de la structure 110,111 pourra consister en un composant MEMS (microsystèmes électromécaniques) radiofréquence, comprenant par exemple au moins un élément de commande et un élément de commutation MEMS consistant par exemple en un micro-commutateur à contact ohmique ou en un micro-commutateur capacitif.

L'un des substrats 100, 101, 102 pourra être utilisé comme substrat support du composant MEMS ; la fabrication de la partie MEMS est ensuite basée sur des dépôts successifs d'une pluralité de couches (incluant une électrode, un diélectrique, une couche sacrificielle, une couche active) et par la réalisation de motifs sur ces différentes couches.

Les premières zones 11 auront par exemple la forme d'hexagones de 10 microns de coté, espacés de 10 microns et la partie supérieure 200 s'étendra sur 50 microns d'épaisseur (profondeur des tranchées 2 remplies par le deuxième matériau 20). Le premier matériau 10' pourra être du silicium monocristallin et le deuxième matériau 20 du nitrure de silicium.

Les procédés microélectroniques pour la fabrication du ou des élément(s) de commande (CMOS par exemple), habituellement réalisée avant la partie MEMS, requièrent, comme dans le mode de réalisation précédent, l'application de traitements thermiques à hautes températures.

Selon une variante de l'invention, pouvant s'appliquer à tous les modes de mise en œuvre décrits, le maillage formé par la deuxième zone 21 sur la première face 1 du substrat 100 pourra être localisé dans des régions déterminées de la première face. On pourra ainsi avoir une pluralité de deuxièmes zones 21, réparties sur la première face 1 du substrat 100. Dans les régions de la première face 1 dépourvues de ces deuxièmes zones 21, on ne trouve donc que le premier matériau 10' du substrat support 10. Les éléments de commande (CMOS) du dispositif, s'ils ne nécessitent pas un substrat sous-jacent présentant des propriétés de résistivité, de permittivité contraignantes comme les éléments RF, pourront être élaborés dans les régions dépourvues de deuxièmes zones 21 (cad dépourvues de tranchées 2).

Comme évoqué précédemment, les signaux hautes fréquences se propageant dans ce dispositif 50 génèrent des champs électromagnétiques (notamment au niveau des éléments de commutation MEMS) qui pénètrent dans le substrat support 10. Les pertes (pertes d'insertion), distorsions (harmoniques) et perturbations seront moindres du fait de la résistivité effective haute et stable de la partie supérieure 200 du substrat support 10 comprenant des tranchées remplies du deuxième matériau 20.

La structure 110,111 présentera des propriétés favorables de dissipation thermique, le premier matériau étant du silicium. Le couplage capacitif entre la couche de dispositifs 50 et le substrat support 10 sera fortement diminué du fait de la permittivité moyenne de la partie supérieure 200, réduite par rapport à celle du silicium par la présence des tranchées remplies du deuxième matériau (hautement résistif ou isolant).

Selon encore un autre mode de réalisation de l'invention, le dispositif microélectronique 50 de la structure 110,111 pourra consister en un filtre radiofréquence, fonctionnant par propagation d'onde acoustique de volume (appelé « BAW » pour « Bulk Acoustic Wave » selon l'appellation anglo-saxonne) ou par propagation d'onde acoustique de surface (appelé « SAW » pour « Surface Acoustic Wave » selon l'appellation anglo-saxonne) ou tout autre mode de propagation acoustique.

La fabrication d'un filtre SAW nécessite par exemple une couche utile 40 constituée d'un matériau piézoélectrique, à la surface de laquelle sera élaboré un peigne d'électrodes : l'onde acoustique est destinée à se propager entre ces électrodes. La structure 110 selon l'invention pourra donc comporter, à titre d'exemple, une couche utile 40 de tantalate de lithium d'épaisseur comprise entre 200 nm et 20 µm.

Les premières zones 11 pourront avoir une forme circulaire de 5 microns de diamètre, espacées de 5 microns et la partie supérieure 200 pourra d'étendre sur 100 microns d'épaisseur (profondeur des tranchées 2). Le premier matériau 10' est du silicium monocristallin et le deuxième matériau 20 pourra être de l'air ou du silicium amorphe ou poly-cristallin. Une couche diélectrique 30 peut optionnellement être ajoutée entre la couche utile 40 et la première face 1 du substrat support 10.

La structure 110, outre le fait qu'elle soit naturellement plus stable en température qu'un substrat piézoélectrique massif, permet l'obtention de meilleures performances de filtres, notamment en terme de pertes d'insertion et de linéarité.

Les substrats 100,101,102 et les structures 110,111 pour applications radiofréquences selon l'invention ne sont pas limités aux modes de mise en œuvre cités ci-dessus. Ils sont adaptés à toute application pour laquelle des signaux hautes fréquences se propagent et sont susceptibles de subir des pertes ou des perturbations non souhaitées dans un substrat support : en effet, les caractéristiques physiques et électriques de la partie supérieure 200 du substrat confèrent à l'ensemble de bonnes propriétés RF (limitant les pertes, non linéarités et autres perturbations), stables sur toute la gamme de température d'utilisation. Elles confèrent également de bonnes propriétés de conductivité thermique, ainsi qu'une une permittivité relative inférieure à 11 permettant un faible couplage capacitif entre la couche active et le substrat support 10. Par le choix des dimensions des premières 11 et deuxième 21 zones et de la nature des premier 10', deuxième 20 et potentiellement troisième 23 matériaux, il est possible de privilégier certaines performances (résistivité effective, stabilité en température, conductibilité thermique, permittivité) par rapport aux autres ; en fonction des applications, des compromis peuvent ainsi être trouvés, d'une part pour répondre aux spécifications des dispositifs microélectroniques à élaborer, mais également pour respecter un coût de fabrication du substrat 100,101,102 permettant son adoption massive.

Les substrats 100,101,102 et les structures 110,111 selon l'invention pourront notamment présenter un intérêt pour des dispositifs combinant des fonctions RF avec des fonctions digitales ou analogiques hautes performances (c'est-à-dire ayant de hautes fréquences de fonctionnement f_{T}, fₘₐₓ).

Dans certains cas, les fonctions digitales et/ou analogiques ne requièrent pas un substrat résistif présentant les propriétés selon l'invention : la partie supérieure 200 du substrat selon l'invention, comportant les tranchées remplies du deuxième matériau 20, peut alors être locale et non présente sur l'ensemble du substrat 100,101,102. Il existe ainsi une pluralité de deuxièmes zones 21 sur la première face 1 du substrat, localisées dans différentes régions de la première face. Dans les régions de la première face 1 dépourvues de ces deuxièmes zones 21, on ne trouve donc que le premier matériau 10' du substrat support 10. Les fonctions digitales et/ou analogiques du dispositif, si elles ne nécessitent pas un substrat sous-jacent présentant des propriétés de résistivité et de permittivité contraignantes comme les composants RF, pourront être élaborées dans les régions dépourvues de deuxièmes zones 21 (cad dépourvues de tranchées 2).

Bien entendu, l'invention n'est pas limitée aux modes de réalisation et aux exemples décrits.

## Revendications

1. Substrat (100,101,102) pour des dispositifs microélectroniques radiofréquences comprenant :
• un substrat support (10) en un premier matériau (10') semi-conducteur de résistivité supérieure à 500 ohm.cm,
• une pluralité de tranchées (2) dans le substrat support (10), remplies d'un deuxième matériau (20), et définissant sur une première face (1) du substrat support (10), une pluralité de premières zones (11) en premier matériau (10') et au moins une deuxième zone (21) en deuxième matériau (20) ;
Le substrat (100,101,102) étant **caractérisé en ce que** :
• le deuxième matériau (20) présente une résistivité supérieure à 10kohms.cm ;
• les premières zones (11) présentent une dimension maximale inférieure à 10 microns et sont isolées les unes des autres par la deuxième zone (21)
• la densité surfacique des premières zones (11) et de la deuxième zone (21) confère à une partie supérieure (200) du substrat s'étendant de la première face (1) du substrat support (10) jusqu'à une profondeur des tranchées (2), une conductibilité thermique moyenne supérieure à 20W/m.K, une permittivité diélectrique moyenne inférieure à la permittivité du premier matériau (10') et une résistivité supérieure à la résistivité du premier matériau (10').

2. Substrat (100,101,102) pour des dispositifs microélectroniques radiofréquences selon la revendication précédente, dans lequel la deuxième zone (21) forme un maillage sur la première face (1) du substrat support (10).

3. Substrat (100,101,102) pour des dispositifs microélectroniques radiofréquences selon l'une des revendications précédentes, dans lequel la profondeur des tranchées (2) est comprise entre 1 micron et 100 microns.

4. Substrat (100,101,102) pour des dispositifs microélectroniques radiofréquences selon l'une des revendications précédentes, dans lequel le premier matériau (10') constituant le substrat support (10) est du silicium.

5. Substrat (100,101,102) pour des dispositifs microélectroniques radiofréquences selon l'une des revendications précédentes, dans lequel le deuxième matériau (20) remplissant les tranchées (2) est choisi parmi un oxyde de silicium, un nitrure de silicium, un oxynitrure de silicium, un nitrure d'aluminium, un silicium amorphe ou poly-cristallin, un silicium riche en carbone, un polymère ou encore un gaz.

6. Substrat (100,101,102) pour des dispositifs microélectroniques radiofréquences selon l'une des revendications précédentes, dans lequel la pluralité de tranchées (2) est remplie partiellement du deuxième matériau (20) et partiellement d'un troisième matériau, de nature ou de composition différente du deuxième matériau (20) .

7. Substrat (100,101,102) pour des dispositifs microélectroniques radiofréquences selon la revendication précédente, dans lequel le troisième matériau (23) est choisi parmi un oxyde de silicium, un nitrure de silicium, un oxynitrure de silicium, un nitrure d'aluminium, un silicium amorphe ou poly-cristallin, un silicium riche en carbone, un polymère ou encore un gaz.

8. Substrat (100,101,102) pour des dispositifs microélectroniques radiofréquences selon l'une des revendications précédentes, comprenant une couche diélectrique (30) disposée sur la première face (1) du substrat support (10).

9. Substrat (100,101,102) pour des dispositifs microélectroniques radiofréquences selon la revendication précédente et la revendication 6, comprenant une couche additionnelle (24) entre la couche diélectrique (30) et la première face (1) du substrat support, composée du troisième matériau.

10. Substrat (100,101,102) pour des dispositifs microélectroniques radiofréquences selon l'une des deux revendications précédentes, dans laquelle la couche diélectrique (30) est formée d'un matériau choisi parmi un oxyde de silicium, un nitrure de silicium, un oxynitrure de silicium, un nitrure d'aluminium.

11. Substrat (100,101,102) pour des dispositifs microélectroniques radiofréquences selon l'une des trois revendications précédentes, dans laquelle la couche diélectrique (30) est composée du deuxième matériau (20).

12. Substrat (100,101,102) pour des dispositifs microélectroniques radiofréquences selon l'une des revendications précédentes, comprenant une couche utile (40) disposée sur la première face (1) du substrat support (10) .

13. Substrat (100,101,102) pour des dispositifs microélectroniques radiofréquences selon la revendication précédente et la revendication 8, dans lequel la couche diélectrique (30) est intercalée entre la couche utile (40) et la première face (1) du substrat support (10).

14. Substrat (100,101,102) pour des dispositifs microélectroniques radiofréquences selon l'une des deux revendications précédentes, dans lequel la couche utile (40) est composée d'un matériau choisi parmi les matériaux semi-conducteurs, isolants ou conducteur, ou encore les matériaux piézoélectriques.

15. Structure (110,111) de dispositifs microélectroniques radiofréquences comprenant :
• un substrat (100,101,102) selon l'une des revendications précédentes ;
• une couche (50) de dispositifs microélectroniques disposée sur le substrat (100,101,102) ;

16. Structure (110,111) de dispositifs microélectroniques radiofréquences selon la revendication précédente, dans laquelle le dispositif microélectronique est un commutateur ou adaptateur d'antenne ou un amplificateur de puissance ou un amplificateur faible bruit ou un composant passif ou autre circuit fonctionnant à haute fréquence ou un composant MEMS radiofréquence ou un filtre radiofréquence.

17. Procédé de fabrication d'un substrat (100,101,102) pour des dispositifs microélectroniques radiofréquences, comprenant :
• La fourniture d'un substrat support (10) en un premier matériau (10') semi-conducteur de résistivité supérieure à 500 ohm.cm, comportant une première face (1) ;
• La gravure selon un masque d'une pluralité de tranchées (2) s'étendant de la première face (1) du substrat support (10) jusqu'à une profondeur déterminée ;
• Le remplissage de la pluralité de tranchées (2) avec un deuxième matériau (20) pour former, sur la première face (1), des premières zones (11) en premier matériau (10') et au moins une deuxième zone (21) en deuxième matériau (20) ;
Le procédé étant **caractérisé en ce que** les premières zones (11), dont une dimension maximale est inférieure à 10 microns, sont isolées les unes des autres par la deuxième zone (21) dont le deuxième matériau (20) présente une résistivité supérieure à 10kohms.cm, et **en ce que** la densité surfacique des premières zones (11) et de la deuxième zone (21) confère à une partie supérieure (200) du substrat s'étendant de la première face (1) du substrat support (10) jusqu'à la profondeur déterminée, une conductibilité thermique moyenne supérieure à 20W/m.K, une permittivité diélectrique moyenne inférieure à la permittivité du premier matériau (10') et une résistivité supérieure à la résistivité du premier matériau (10').

18. Procédé de fabrication d'un substrat (100,101,102) pour des dispositifs microélectroniques radiofréquences, comprenant :
• La fourniture d'un substrat support (10) en un premier matériau (10') semi-conducteur de résistivité supérieure à 500 ohm.cm ;
• Le dépôt local, selon un masque, d'une pluralité de piliers formés du premier matériau (10') et d'une hauteur déterminée, sur le substrat support (10) ; une surface supérieure des piliers définissant une première face (1) du substrat support (10) et les piliers étant isolés les uns des autres par une pluralité de tranchées (2) s'étendant de la première face (1) du substrat support (10) jusqu'à une profondeur définie par la hauteur déterminée des piliers ;
• Le remplissage de la pluralité de tranchées (2) avec un deuxième matériau (20) pour former, sur la première face (1), des premières zones (11) en premier matériau (10') et au moins une deuxième zone (21) en deuxième matériau (20) ;
Le procédé étant **caractérisé en ce que** les premières zones (11), dont une dimension maximale est inférieure à 10 microns, sont isolées les unes des autres par la deuxième zone (21) dont le deuxième matériau (20) présente une résistivité supérieure à 10kohms.cm. et **en ce que** la densité surfacique des premières zones (11) et de la deuxième zone (21) confère à une partie supérieure (200) du substrat s'étendant de la première face (1) du substrat support (10) jusqu'à la hauteur déterminée, une conductibilité thermique moyenne supérieure à 20W/m.K, une permittivité diélectrique moyenne inférieure à la permittivité du premier matériau (10') et une résistivité supérieure à la résistivité du premier matériau.

## Patentansprüche

1. Substrat (100, 101, 102) für mikroelektronische Hochfrequenzvorrichtungen, umfassend:
• ein Trägersubstrat (10) aus einem ersten Halbleitermaterial (10') mit einem spezifischen Widerstand von mehr als 500 Ohm·cm,
• eine Vielzahl von Gräben (2) in dem Trägersubstrat (10), die mit einem zweiten Material (20) gefüllt sind und auf einer ersten Seite (1) des Trägersubstrats (10) mehrere erste Zonen (11) aus erstem Material (10') und mindestens eine zweite Zone (21) aus zweitem Material (20) definieren;
wobei das Substrat (100, 101, 102) **dadurch gekennzeichnet ist, dass**:
• das zweite Material (20) einen spezifischen Widerstand von mehr als 10 kOhm·cm aufweist;
• die ersten Zonen (11) eine maximale Abmessung von weniger als 10 Mikrometern aufweisen und durch die zweite Zone (21) voneinander isoliert sind,
• die Oberflächendichte der ersten Zonen (11) und der zweiten Zone (21) einem oberen Teil (200) des Substrats, der sich von der ersten Seite (1) des Trägersubstrats (10) bis zu einer Tiefe der Gräben (2) erstreckt, eine mittlere Wärmeleitfähigkeit von mehr als 20 W/m·K, eine mittlere dielektrische Permittivität von weniger als der Permittivität des ersten Materials (10') und einen spezifischen Widerstand von mehr als dem spezifischen Widerstand des ersten Materials (10') verleiht.

2. Substrat (100, 101, 102) für mikroelektronische Hochfrequenzvorrichtungen nach dem vorhergehenden Anspruch, wobei die zweite Zone (21) ein Netz auf der ersten Seite (1) des Trägersubstrats (10) bildet.

3. Substrat (100, 101, 102) für mikroelektronische Hochfrequenzvorrichtungen nach einem der vorhergehenden Ansprüche, wobei die Tiefe der Gräben (2) zwischen 1 Mikrometer und 100 Mikrometern liegt.

4. Substrat (100, 101, 102) für mikroelektronische Hochfrequenzvorrichtungen nach einem der vorhergehenden Ansprüche, wobei das erste Material (10'), das das Trägersubstrat (10) bildet, Silicium ist.

5. Substrat (100, 101, 102) für mikroelektronische Hochfrequenzvorrichtungen nach einem der vorhergehenden Ansprüche, wobei das zweite Material (20), das die Gräben (2) füllt, aus Siliciumoxid, Siliciumnitrid, Siliciumoxynitrid, Aluminiumnitrid, amorphem oder polykristallinem Silicium, kohlenstoffreichem Silicium, einem Polymer oder auch einem Gas ausgewählt ist.

6. Substrat (100, 101, 102) für mikroelektronische Hochfrequenzvorrichtungen nach einem der vorhergehenden Ansprüche, wobei die mehreren Gräben (2) teilweise mit dem zweiten Material (20) und teilweise mit einem dritten Material gefüllt sind, dessen Art oder Zusammensetzung sich von der des zweiten Materials (20) unterscheidet.

7. Substrat (100, 101, 102) für mikroelektronische Hochfrequenzvorrichtungen nach dem vorhergehenden Anspruch, wobei das dritte Material (23) aus Siliciumoxid, Siliciumnitrid, Siliciumoxynitrid, Aluminiumnitrid, amorphem oder polykristallinem Silicium, kohlenstoffreichem Silicium, einem Polymer oder auch einem Gas ausgewählt ist.

8. Substrat (100, 101, 102) für mikroelektronische Hochfrequenzvorrichtungen nach einem der vorhergehenden Ansprüche, umfassend eine dielektrische Schicht (30), die auf der ersten Seite (1) des Trägersubstrats (10) angeordnet ist.

9. Substrat (100, 101, 102) für mikroelektronische Hochfrequenzvorrichtungen nach dem vorhergehenden Anspruch und Anspruch 6, umfassend eine zusätzliche Schicht (24) zwischen der dielektrischen Schicht (30) und der ersten Seite (1) des Trägersubstrats, die aus dem dritten Material besteht.

10. Substrat (100, 101, 102) für mikroelektronische Hochfrequenzvorrichtungen nach einem der beiden vorhergehenden Ansprüche, wobei die dielektrische Schicht (30) aus einem Material gebildet ist, das aus Siliciumoxid, Siliciumnitrid, Siliciumoxynitrid, Aluminiumnitrid ausgewählt ist.

11. Substrat (100, 101, 102) für mikroelektronische Hochfrequenzvorrichtungen nach einem der drei vorhergehenden Ansprüche, wobei die dielektrische Schicht (30) aus dem zweiten Material (20) besteht.

12. Substrat (100, 101, 102) für mikroelektronische Hochfrequenzvorrichtungen nach einem der vorhergehenden Ansprüche, umfassend eine Nutzschicht (40), die auf der ersten Seite (1) des Trägersubstrats (10) angeordnet ist.

13. Substrat (100, 101, 102) für mikroelektronische Hochfrequenzvorrichtungen nach dem vorhergehenden Anspruch und Anspruch 8, wobei die dielektrische Schicht (30) zwischen der Nutzschicht (40) und der ersten Seite (1) des Trägersubstrats (10) eingeschoben ist.

14. Substrat (100, 101, 102) für mikroelektronische Hochfrequenzvorrichtungen nach einem der beiden vorhergehenden Ansprüche, wobei die Nutzschicht (40) aus einem Material besteht, das aus Halbleiter-, isolierenden oder leitenden Materialien oder auch piezoelektrischen Materialien ausgewählt ist.

15. Struktur (110, 111) von mikroelektronischen Hochfrequenzvorrichtungen, umfassend:
• ein Substrat (100, 101, 102) nach einem der vorhergehenden Ansprüche;
• eine Schicht (50) von mikroelektronischen Vorrichtungen, die auf dem Substrat (100, 101, 102) angeordnet sind;

16. Struktur (110, 111) von mikroelektronischen Hochfrequenzvorrichtungen nach dem vorhergehenden Anspruch, wobei die mikroelektronische Vorrichtung ein Antennenschalter oder -adapter oder ein Leistungsverstärker oder ein rauscharmer Verstärker oder eine passive Komponente oder eine andere Schaltung, die bei Hochfrequenz arbeitet, oder eine Hochfrequenz-MEMS-Komponente oder ein Hochfrequenzfilter ist.

17. Verfahren zur Herstellung eines Substrats (100, 101, 102) für mikroelektronische Hochfrequenzvorrichtungen, umfassend:
• Bereitstellen eines Trägersubstrats (10) aus einem ersten Halbleitermaterial (10') mit einem spezifischen Widerstand von mehr als 500 Ohm·cm, umfassend eine erste Seite (1);
• Ätzen mehrerer Gräben (2), die sich von der ersten Seite (1) des Trägersubstrats (10) bis zu einer bestimmten Tiefe erstrecken, gemäß einer Maske;
• Füllen der mehreren Gräben (2) mit einem zweiten Material (20), um auf der ersten Seite (1) erste Zonen (11) aus erstem Material (10') und mindestens eine zweite Zone (21) aus zweitem Material (20) zu bilden;
wobei das Verfahren **dadurch gekennzeichnet ist, dass** die ersten Zonen (11), deren maximale Abmessung weniger als 10 Mikrometer beträgt, durch die zweite Zone (21), deren zweites Material (20) einen spezifischen Widerstand von mehr als 10 kOhm·cm aufweist, voneinander isoliert sind, und dadurch, dass die Oberflächendichte der ersten Zonen (11) und der zweiten Zone (21) einem oberen Teil (200) des Substrats, der sich von der ersten Seite (1) des Trägersubstrats (10) bis zur bestimmten Tiefe erstreckt, eine mittlere Wärmeleitfähigkeit von mehr als 20 W/m·K, eine mittlere dielektrische Permittivität von weniger als der Permittivität des ersten Materials (10') und einen spezifischen Widerstand von mehr als dem spezifischen Widerstand des ersten Materials (10') verleiht.

18. Verfahren zur Herstellung eines Substrats (100, 101, 102) für mikroelektronische Hochfrequenzvorrichtungen, umfassend:
• Bereitstellen eines Trägersubstrats (10) aus einem ersten Halbleitermaterial (10') mit einem spezifischen Widerstand von mehr als 500 Ohm·cm;
• lokales Abscheiden mehrerer Säulen, die aus dem ersten Material (10') gebildet sind, und in einer bestimmten Höhe auf das Trägersubstrat (10) gemäß einer Maske; wobei eine obere Oberfläche der Säulen eine erste Seite (1) des Trägersubstrats (10) definiert und die Säulen durch mehrere Gräben (2) voneinander isoliert sind, die sich von der ersten Seite (1) des Trägersubstrats (10) bis zu einer Tiefe erstrecken, die durch die bestimmte Höhe der Säulen definiert ist;
• Füllen der mehreren Gräben (2) mit einem zweiten Material (20), um auf der ersten Seite (1) erste Zonen (11) aus erstem Material (10') und mindestens eine zweite Zone (21) aus zweitem Material (20) zu bilden;
wobei das Verfahren **dadurch gekennzeichnet ist, dass** die ersten Zonen (11), deren maximale Abmessung weniger als 10 Mikrometer beträgt, durch die zweite Zone (21), deren zweites Material (20) einen spezifischen Widerstand von mehr als 10 kOhm·cm aufweist, voneinander isoliert sind, und dadurch, dass die Oberflächendichte der ersten Zonen (11) und der zweiten Zone (21) einem oberen Teil (200) des Substrats, der sich von der ersten Seite (1) des Trägersubstrats (10) bis zur bestimmten Höhe erstreckt, eine mittlere Wärmeleitfähigkeit von mehr als 20 W/m·K, eine mittlere dielektrische Permittivität von weniger als der Permittivität des ersten Materials (10') und einen spezifischen Widerstand von mehr als dem spezifischen Widerstand des ersten Materials (10') verleiht.

## Claims

1. Substrate (100, 101, 102) for radio-frequency microelectronic devices comprising:
• a support substrate (10) made of a first semiconductor material (10') with resistivity of more than 500 ohm.cm;
• a plurality of trenches (2) in the support substrate (10), filled with a second material (20), and defining, on a first face (1) of the support substrate (10), a plurality of first zones (11) made of a first material (10') and at least one second zone (21) made of a second material (20);
the substrate (100, 101, 102) being **characterized in that**:
• the second material (20) has a resistivity of more than 10 kohms.cm;
• the first zones (11) have a maximum dimension of less than 10 microns and are isolated from each other by the second zone (21);
• the surface density of the first zones (11) and of the second zone (21) provides an upper part (200) of the substrate, extending from the first face (1) of the support substrate (10) to a depth of the trenches (2), with an average thermal conductivity of more than 20 W/mK, an average dielectric permittivity that is less than the permittivity of the first material (10') and a resistivity that is greater than the resistivity of the first material (10').

2. Substrate (100, 101, 102) for radio-frequency microelectronic devices according to the preceding claim, wherein the second zone (21) forms a mesh on the first face (1) of the support substrate (10).

3. Substrate (100, 101, 102) for radio-frequency microelectronic devices according to one of the preceding claims, wherein the depth of the trenches (2) is between 1 micron and 100 microns.

4. Substrate (100, 101, 102) for radio-frequency microelectronic devices according to one of the preceding claims, wherein the first material (10') constituting the support substrate (10) is silicon.

5. Substrate (100, 101, 102) for radio-frequency microelectronic devices according to one of the preceding claims, wherein the second material (20) filling the trenches (2) is selected from a silicon oxide, a silicon nitride, a silicon oxynitride, an aluminum nitride, an amorphous or polycrystalline silicon, a carbon-rich silicon, a polymer or even a gas.

6. Substrate (100, 101, 102) for radio-frequency microelectronic devices according to one of the preceding claims, wherein the plurality of trenches (2) is partially filled with the second material (20) and is partially filled with a third material, with a nature or composition that differs from the second material (20).

7. Substrate (100, 101, 102) for radio-frequency microelectronic devices according to the preceding claim, wherein the third material (23) is selected from a silicon oxide, a silicon nitride, a silicon oxynitride, an aluminum nitride, an amorphous or polycrystalline silicon, a carbon-rich silicon, a polymer or even a gas.

8. Substrate (100, 101, 102) for radio-frequency microelectronic devices according to one of the preceding claims, comprising a dielectric layer (30) arranged on the first face (1) of the support substrate (10).

9. Substrate (100, 101, 102) for radio-frequency microelectronic devices according to the preceding claim and according to claim 6, comprising an additional layer (24) between the dielectric layer (30) and the first face (1) of the support substrate, composed of the third material.

10. Substrate (100, 101, 102) for radio-frequency microelectronic devices according to one of the two preceding claims, wherein the dielectric layer (30) is formed from a material selected from a silicon oxide, a silicon nitride, a silicon oxynitride, an aluminum nitride.

11. Substrate (100, 101, 102) for radio-frequency microelectronic devices according to one of the three preceding claims, wherein the dielectric layer (30) is composed of the second material (20).

12. Substrate (100, 101, 102) for radio-frequency microelectronic devices according to one of the preceding claims, comprising a useful layer (40) arranged on the first face (1) of the support substrate (10).

13. Substrate (100, 101, 102) for radio-frequency microelectronic devices according to the preceding claim and according to claim 8, wherein the dielectric layer (30) is interposed between the useful layer (40) and the first face (1) of the support substrate (10).

14. Substrate (100, 101, 102) for radio-frequency microelectronic devices according to one of the two preceding claims, wherein the useful layer (40) is composed of a material selected from semiconductor, insulating or conductive materials, or even piezoelectric materials.

15. Structure (110, 111) of radio-frequency microelectronic devices comprising:
• a substrate (100, 101, 102) according to one of the preceding claims;
• a layer (50) of microelectronic devices arranged on the substrate (100, 101, 102).

16. Structure (110, 111) of radio-frequency microelectronic devices according to the preceding claim, wherein the microelectronic device is an antenna switch or adapter or a power amplifier or a low noise amplifier or a passive component or other circuit operating at high frequency or an MEMS radio-frequency component or a radio-frequency filter.

17. Method for producing a substrate (100, 101, 102) for radio-frequency microelectronic devices, comprising:
• supplying a support substrate (10) made of a first semiconductor material (10') with resistivity of more than 500 ohm.cm, comprising a first face (1);
• etching, along a mask, a plurality of trenches (2) extending from the first face (1) of the support substrate (10) to a determined depth;
• filling the plurality of trenches (2) with a second material (20) to form, on the first face (1), first zones (11) made of a first material (10') and at least one second zone (21) made of a second material (20);
the method being **characterized in that** the first zones (11), the maximum dimension of which is less than 10 microns, are isolated from each other by the second zone (21), the second material (20) of which has a resistivity of more than 10 kohms.cm, and **in that** the surface density of the first zones (11) and of the second zone (21) provides an upper part (200) of the substrate, extending from the first face (1) of the support substrate (10) to the determined depth, with an average thermal conductivity of more than 20 W/mK, an average dielectric permittivity that is less than the permittivity of the first material (10') and a resistivity that is greater than the resistivity of the first material (10').

18. Method for producing a substrate (100,101,102) for radio-frequency microelectronic devices, comprising:
• supplying a support substrate (10) made of a first semiconductor material (10') with resistivity of more than 500 ohm.cm;
• locally depositing, along a mask, a plurality of pillars formed from the first material (10') and of a determined height onto the support substrate (10), with an upper surface of the pillars defining a first face (1) of the support substrate (10) and the pillars being isolated from each other by a plurality of trenches (2) extending from the first face (1) of the support substrate (10) to a depth defined by the determined height of the pillars;
• filling the plurality of trenches (2) with a second material (20) to form, on the first face (1), first zones (11) made of a first material (10') and at least one second zone (21) made of a second material (20);
the method being **characterized in that** the first zones (11), the maximum dimension of which is less than 10 microns, are isolated from each other by the second zone (21), the second material (20) of which has a resistivity of more than 10 kohms.cm, and **in that** the surface density of the first zones (11) and of the second zone (21) provides an upper part (200) of the substrate, extending from the first face (1) of the support substrate (10) to the determined height, with an average thermal conductivity of more than 20 W/mK, an average dielectric permittivity that is less than the permittivity of the first material (10') and a resistivity that is greater than the resistivity of the first material.
